# EUROPEAN PATENT APPLICATION

(11) **EP 2 186 923 A1**
(43) Date of publication of application: **19.05.2010**
(21) Application number: 08167337.8
(22) Date of filing: 22.10.2008
(51) Int. Cl.: C23C 16/44

(54) **Gas supply system, pumping system, coating system, gas supply method, and pumping method**

(71) Applicant: Applied Materials, Inc., Santa Clara, CA 95054 (US)
(72) Inventor: Gebele, Thomas, 63579, Freigericht (DE); Henrich, Juergen, 63694, Limeshain (DE); Leipnitz, Thomas, 63755, Alzenau (DE); Klein, Stefan, 63743, Aschaffenburg (DE)
(74) Representative: Zimmermann & Partner

(57) **Abstract**

A gas supply system 20 for supplying a gas into a pumping system 10 is provided, the pumping system including a plurality of pumping means 14, 16, the gas supply system comprising a gas inlet 22 and plurality of gas conduits 24, 25 fluidly connected to the gas inlet and each having a gas outlet 27, 28 fluidly connectable to the pumping system 10, wherein the gas outlets of the plurality of gas conduits are in parallel fluidly connectable to the pumping system and each gas conduit is provided with a gradient adjustment means adapted to provide at least one gradient of gas amount supplied to the pumping system.

## Description

### FIELD OF THE INVENTION

Embodiments of the invention generally relate to pumping of gases. More particularly, embodiments relate to a gas supply system, a pumping system, a coating system, a gas supply method and a pumping method. Specifically, embodiments disclosed herein relate to pumping of gases in vacuum.

### BACKGROUND OF THE INVENTION

Multi stage pumping apparatuses have many functions in a plurality of industrial fields, including, but not limited to, thin-film deposition applications, e.g. in the production of displays, in solar wafer manufacturing or in semiconductor device production.

For instance in vacuum coating installations for the manufacture of thin film solar cells, processes are utilized, in which large amounts of gases having a small molecular weight, such as Hydrogen and gas mixtures including large amounts of Hydrogen, are pumped at pressures in the range of, e.g. about 1 Pa to about 2000 Pa (about 0.01 mbar to about 20 mbar). In some instances, during cleaning and/or etching procedures other gases, such as Halogen containing gases, e.g. gases containing Fluorine and/or Fluorine compounds, have to be pumped.

Typically, multi stage pumping apparatuses may include a plurality of consecutively mounted pumps. A typical multi stage pumping apparatus includes, for instance, at least one forepump, e.g. a backing pump, and at least one further pump, such as a booster pump. The backing pump typically provides a backing pressure for the booster pumps. The backing pump may be selected from dry running pumps, such as a screw pump, a claw pump or a multi stage rootspump. The further pump may also be chosen from dry running pumps, e.g. a booster pump which may also be referred to as a rootspump. Hence, the backing pump as well as the further pump may result in an internal gas backstreaming, which reduces the pumping efficiency. Typically, this effect of gas backstreaming is the more pronounced, the smaller the molecular weight of the pumped gas is. For instance, Helium, having a molecular weight of about 4 u, is pumped with a smaller efficiency than e.g. Nitrogen (molecular weight of about 28 u), air (molecular weight of about 29 u) or Argon (molecular weight of about 40 u). As compared to other gases, particularly Hydrogen (molecular weight of about 2 u) may be pumped with a low efficiency.

### SUMMARY

In light of the above, a gas supply system according to claim 1, a pumping system according to claim 7, a coating system according to claim 12, a gas supply method according to claim 13, and a pumping method according to claim 14 are provided.

According to one embodiment, a gas supply system for supplying a gas into a pumping system is provided, the pumping system including a plurality of pumping means, the gas supply system including a gas inlet and plurality of gas conduits fluidly connected to the gas inlet and each having a gas outlet fluidly connectable to the pumping system, wherein the gas outlets of the plurality of gas conduits are in parallel fluidly connectable to the pumping system and each gas conduit is provided with a gradient adjustment means adapted to provide at least one gradient of gas amount supplied to the pumping system.

In a further embodiment, a pumping system is provided, including a pumping conduit, a plurality of pumping means, and a gas supply system including a gas inlet and including a plurality of gas conduits fluidly connected to the gas inlet and each having a gas outlet fluidly connectable to the pumping system, wherein each gas conduit is provided with a gradient adjustment means adapted to provide at least one gradient of gas amount supplied to the pumping system, and wherein the gas outlets of the plurality of gas conduits are in parallel fluidly connected to the pumping system.

In another embodiment, a coating system is provided, including a coating chamber and a gas supply system for supplying a gas into a pumping system of the coating chamber, the pumping system including a plurality of pumping means, the gas supply system including a gas inlet and plurality of gas conduits fluidly connected to the gas inlet and each having a gas outlet fluidly connectable to the pumping system, wherein the gas outlets of the plurality of gas conduits are in parallel fluidly connectable to the pumping system and each gas conduit is provided with a gradient adjustment means adapted to provide at least one gradient of gas amount supplied to the pumping system.

In one embodiment, a coating system is provided, including a coating chamber and a pumping system including a pumping conduit, a plurality of pumping means, and a gas supply system including a gas inlet and including a plurality of gas conduits fluidly connected to the gas inlet and each having a gas outlet fluidly connectable to the pumping system, wherein each gas conduit is provided with a gradient adjustment means adapted to provide at least one gradient of gas amount supplied to the pumping system, and wherein the gas outlets of the plurality of gas conduits are in parallel fluidly connected to the pumping system.

According to a yet further embodiment, a gas supply method for supplying a gas into a pumping system is provided, the pumping system including a plurality of pumping means, the method including: supplying a gas into the pumping system through a first gas conduit and at least another gas conduit, the first gas conduit and the at least another gas conduit being fluidly connected to the pumping system in parallel to each other; and adjusting at least the amount of gas supplied through the first gas conduit such that at least one gradient of the gas amount supplied into the pumping system is provided.

In another embodiment, a pumping method for pumping a process gas by a pumping system is provided, the pumping system including a process gas inlet and a plurality of pumping means, the method including supplying a gas into the pumping system through a first gas conduit and at least another gas conduit, the first gas conduit and the at least another gas conduit being fluidly connected to the pumping system in parallel to each other, adjusting at least the amount of gas supplied through the first gas conduit such that at least one gradient of the gas amount supplied into the pumping system is provided, and pumping a process gas introduced through the process gas inlet.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features of the present invention can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments with reference to the following drawings in which:

Figs. 1a and 1b schematically show a gas supply system and a pumping system according to examples of embodiments;

Figs. 2a and 2b schematically show a gas supply system and a pumping system according to examples of embodiments;

Fig. 3 schematically shows a pumping system including a gas supply system according to an example of embodiments;

Figs. 4a to 4c schematically show pumping systems including gas supply systems according to examples of embodiments;

Fig. 5a and 5b schematically show each a pumping system including two gas supply systems according to examples of embodiments;

Fig. 6 schematically shows a pumping system including two gas supply systems according to an example of embodiments; and

Fig. 7 schematically shows a pumping system including two gas supply systems according to an example of embodiments.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following the gas supply system, the pumping system, the coating system, and the pumping method of embodiments disclosed herein are described referring to a coating application, e.g. a CVD (Chemical Vapor Deposition) or a PECVD (Plasma Enhanced Chemical Vapor Deposition) process. However, other applications of embodiments may be contemplated, which include processes, e.g. an etching process, performed in a process chamber and resulting in a process gas or exhaust gas to be pumped. The pumping system of embodiments may for example be referred to as multi stage pumping installation. Further, a coating system of embodiments may include a coating chamber, also referred to herein as a process chamber.

Within the following description of the drawings, the same reference numbers refer to the same components. Generally, only the differences with respect to the individual embodiments are described.

A typical application of embodiments disclosed herein is in coating installations, such as a vacuum coating installation. Examples of such coating installations are devices for thin-film deposition applications, e.g. in the production of displays, such as LCD or OLED displays, in solar device manufacturing, such as solar wafers, solar panels, solar thin-film panels, or in semiconductor device production. The substrates to be coated may be rigid, for example glass plates, or non-rigid, such as flexible webs. In particular, embodiments disclosed herein may be utilized in coating installations, in which one or more gases are used, e.g. gases having a small molecular weight, such as Hydrogen or gas mixtures including Hydrogen. Embodiments may be utilized especially in CVD coating installations, such as PECVD coating installations, using large amounts of one or more gases having a small molecular weight for coating large substrates. Typically, embodiments disclosed herein may be applied to CVD coating installations for the manufacture of solar devices, for instance with a Hydrogen flow of about 50 slm to about 1000 slm. The term slm stands for "standard liters per minute" and measures a gas volume at about 0°C and about 1013hPa (1 atm). The term slm is further a measure of molar flow of a gas or a gas mixture, which are often assumed to be an ideal gas. It is used e.g. for quantifying the amount of a gas or a gas mixture used or produced in a vacuum coating process, such as a CVD process. As a measure of molar flow of a gas, 1 slm may correspond to e.g. about 7.4E-4 moles/second. Typically, 1 slm corresponds to 1000 sccm (Standard Cubic Centimeters).

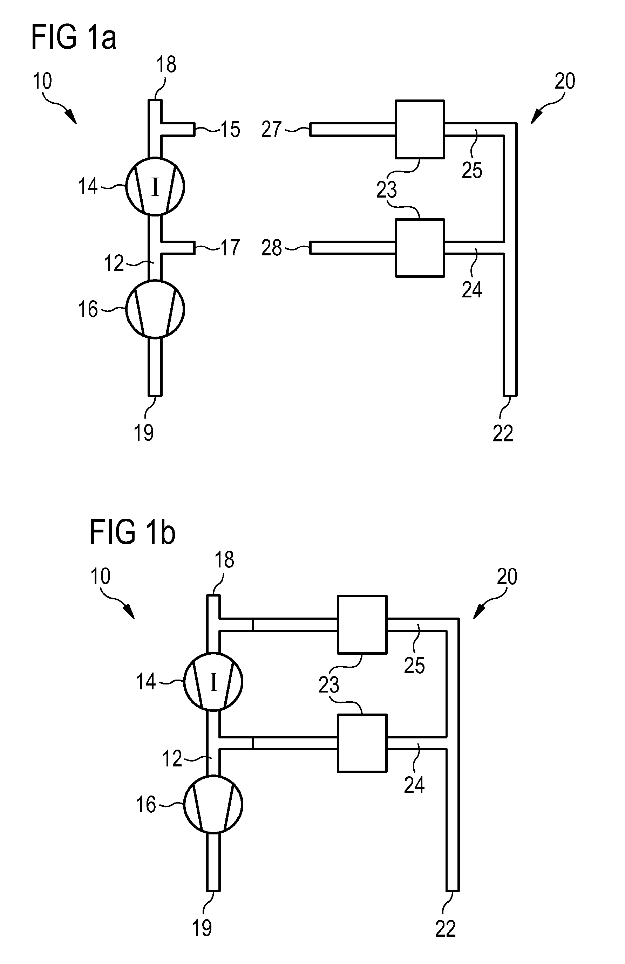

Fig. 1a shows a typical multi stage pumping installation 10, also referred to as pumping system 10, and a gas supply system 20 of examples of embodiments disclosed herein. The pumping system 10 includes a pumping conduit 12 and a plurality of pumps 14, 16 consecutively mounted in the pumping conduit 12. The pumping conduit 12 has an upstream end 18 and a downstream end 19. The upstream end 18 is a process gas inlet which may be connected to a process chamber, such as a coating chamber for CVD for the production of solar wafers. The downstream end 19 of the pumping conduit 12 is an exhaust gas outlet, i.e. an exhaust for the gases which are pumped in the pumping system.

Typically, the multi stage pumping installation includes at least one backing pump and at least one further pump for pumping a process gas, e.g. an exhaust gas mixture, out of a process chamber. In a typical example of embodiments, the multi stage pumping installation 10 includes one backing pump 16 and at least one further pump which is a booster pump 14. The backing pump 16, which may also be referred to as forepump, typically provides a backing pressure for the booster pump 14. The backing pump 16 may be selected from oil sealed pumps, such as a rotary vane pump, a rotary plunger pump, and a trochoid pump, as well as from dry running pumps, such as a screw pump, a claw pump or a multi stage rootspump. The booster pump 14 is also a dry running pump, and is a rootspump, which may typically have a comparatively low compression. For instance, a rootspump may typically have a relatively small compression in the range of about 1:5 to about 1:10. When selecting dry running pumps as the backing pump and/or further pumps in a multi stage pumping installation, because of the dry running principle and the low compression, the pumps, in the present example the backing pump 16 and/or the booster pump 14, may result in an internal gas backstreaming, which reduces the pumping efficiency and may have adverse effects on processes performed in the process chamber.

According to one embodiment, a gas supply system for supplying a gas into a pumping system is provided, the pumping system including a plurality of pumping means, the gas supply system including a gas inlet and plurality of gas conduits fluidly connected to the gas inlet and each having a gas outlet fluidly connectable to the pumping system, wherein the gas outlets of the plurality of gas conduits are in parallel fluidly connectable to the pumping system and each gas conduit is provided with a gradient adjustment means adapted to provide at least one gradient of gas amount supplied to the pumping system. This allows adjusting the amount of gas supplied through the gas conduits such that at least one gradient of the gas amount supplied into the pumping system may be provided. In one example of embodiments, the gradient adjustment means may include at least one element selected from the group consisting of a gas flow restriction means and a gas flow adjustment means. The gas flow adjustment means may e.g. include a gas flow sensing means and a gas flow restriction means. For instance, the gradient adjustment means may include at least one element selected from the group consisting of an orifice, a nozzle, a valve, a throttle, a flow sensor, a control valve and a gas flow controller. In a further example of embodiments, the gradient adjustment means of at least a first one of the gas conduits includes a gas flow controller having e.g. a flow sensor and a control valve. This allows adjusting at least the amount of gas supplied through the first gas conduit such that at least one gradient of the gas amount supplied into the pumping system may be provided.

In a further embodiment, a pumping system is provided, including a pumping conduit; a plurality of pumping means; and a gas supply system according to any embodiment or example of embodiments described herein; and wherein the gas outlets of the plurality of gas conduits are in parallel fluidly connected to the pumping system. The plurality of pumping means may be consecutively provided in the pumping conduit.

According to a yet further embodiment, a gas supply method for supplying a gas into a pumping system is provided, the pumping system including a plurality of pumping means, the method including: supplying a gas into the pumping system through a first gas conduit and at least another gas conduit, the first gas conduit and the at least another gas conduit being fluidly connected to the pumping system in parallel to each other; and adjusting at least the amount of gas supplied through the first gas conduit such that at least one gradient of the gas amount supplied into the pumping system is provided.

In another embodiment, a pumping method for pumping a process gas by a pumping system is provided, the pumping system including a process gas inlet and a plurality of pumping means, the method including supplying a gas into the pumping system through a first gas conduit and at least another gas conduit, the first gas conduit and the at least another gas conduit being fluidly connected to the pumping system in parallel to each other, adjusting at least the amount of gas supplied through the first gas conduit such that at least one gradient of the gas amount supplied into the pumping system is provided, and pumping a process gas introduced through the process gas inlet. Two or more of the steps of supplying, adjusting and pumping may be performed simultaneously or in any appropriate sequence.

Fig. 1a illustrates a gas supply system 20 according to one example of embodiments. The gas supply system 20 includes a gas inlet 22 and a first gas conduit 25 and a second gas conduit 24, which are both fluidly connected to the gas inlet 22. Each gas conduit 24, 25 has a gas outlet 27, 28. The gas outlets 27, 28 of the gas conduits 24, 25 are in parallel fluidly connectable e.g. to the pumping system 10. The first gas conduit 25 and the second gas conduit 24 are each provided with a gradient adjustment means 23. The gradient adjustment means 23 may be a gas flow restriction means and/or a gas flow adjustment means. According to the present example, each gradient adjustment means 23 is a gas flow restriction means being a throttle. In alternative examples, the gradient adjustment means 23 of one or all gas conduits 24, 25 may be at least one gas flow restriction means selected from the group consisting of a throttle, an orifice, a nozzle or a valve. In each of these examples, the gradient adjustment means 23 is adapted to provide a fixed gas flow through the corresponding gas conduits 24, 25. The fixed gas flow through the gas conduit 24 may be different from the fixed gas flow of the gas conduit 25, thereby providing a gradient of gas amount which can be supplied by the gas supply system 20.

Fig. 1b illustrates one example of embodiments, in which the gas supply system 20 of Fig. 1a is connected to the pumping system 10. In this embodiment, each gas conduit 24, 25 of the gas supply system 20 is connected to the pumping system 10. For connecting the gas supply system 20 and the pumping system 10, each gas outlet 27, 28 of the gas supply system may be provided with a connection means, e.g. a flange (not shown), such as a vacuum flange. Furthermore, each position 15, 17 of the pumping system 10, at which a connection to the gas supply system may be established, is provided with a connection means, e.g. with a flange (not shown), such as a vacuum flange.

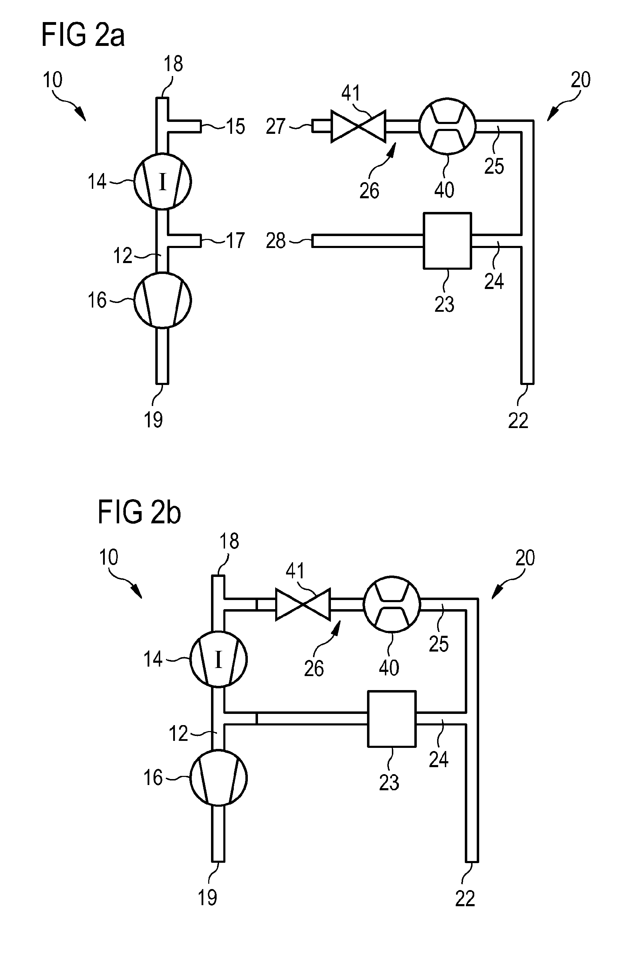

Fig. 2a illustrates the gas supply system 20 modified according to a further example of embodiments. In this example, the first gas conduit 25 is provided with a gas flow controller 26 including a flow sensor 40 and a valve 41 downstream of the flow sensor 40, which may provide a variable gas flow. The second gas conduit 24 has a gradient adjustment means 23 providing a fixed gas flow, e.g. a throttle.

Fig. 2b illustrates one example of embodiments, in which the gas supply system 20 of Fig. 2a is connected to the pumping system 10. In this embodiment, each gas conduit 24, 25 of the gas supply system 20 is connected to pumping system 10. For connecting the gas supply system 20 and the pumping system 10, each gas outlet 27, 28 of the gas supply system may be provided with a connection means, e.g. a flange (not shown), such as a vacuum flange. Furthermore, each position 15, 17 of the pumping system 10, at which a connection to the gas supply system may be established, is provided with a connection means, e.g. with a flange (not shown), such as a vacuum flange.

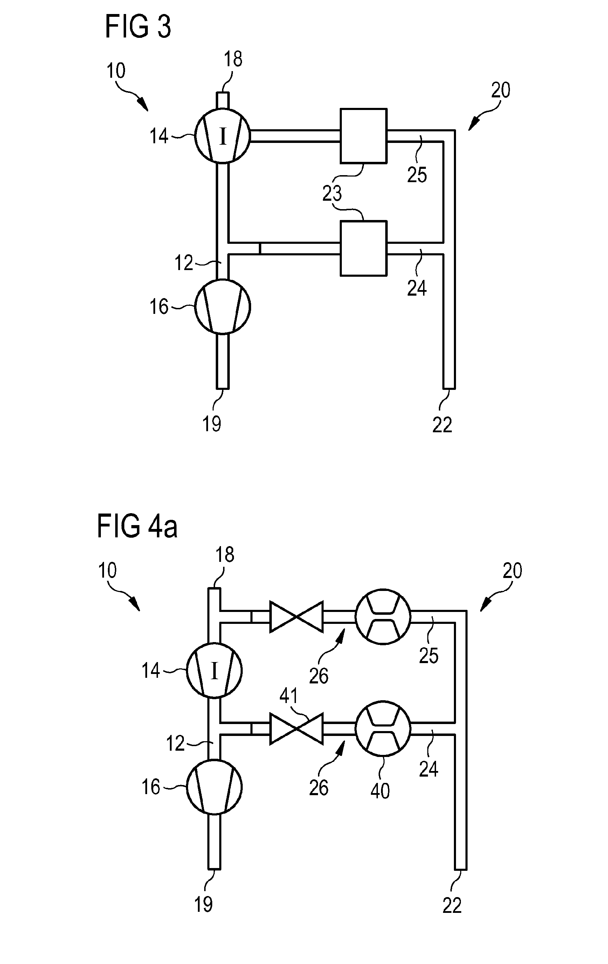

According to some examples of embodiments, each gas conduit 24, 25 of the gas supply system may be provided with a gradient adjustment means 23, as illustrated e.g. in Figs. 1a, 1b and 3. In other examples of embodiments, as shown in Fig. 4a, each gas conduit 24, 25 of the gas supply system 20 may be provided with a gradient adjustment means being a gas flow controller 26, which may include one flow sensor 40 and one valve 41.

As shown above, in the gas supply system of embodiments, each gas conduit is provided with a gradient adjustment means adapted to provide at least one gradient of gas amount supplied to the pumping system. The gradient adjustment means may for example include at least one element selected from the group consisting of a gas flow restriction means and a gas flow adjustment means. For instance, the gradient adjustment means may include at least one element selected from the group consisting of an orifice, a nozzle, a valve, a throttle, a flow sensor, a control valve and a gas flow controller. For example, at least one of the plurality of gas conduits may have a gradient adjustment means being a gas flow controller providing an adjustable gas flow, while the other gas conduits may each have a gradient adjustment means, e.g. a throttle, providing a fixed gas flow. Hence, the gas supply system of embodiments disclosed herein is adapted for adjusting, e.g. controlling, at least the amount of gas supplied through one of the gas conduits. Consequently, at least one gradient of the gas amount supplied into the pumping system may be provided. Therefore, according to embodiments disclosed herein, one or more optimized gradients of amounts of a purge gas introduced into the pumping system may be set. The adjusting of at least the amount of gas supplied through one of the gas conduits may be performed continuously and/or discontinuously. Further, e.g. when at least two gas flow controllers are provided, the adjusting of at least two gas flows may be performed simultaneously.

The gas, which may be supplied by the gas supply system according to embodiments, is e.g. at least one gas selected from the group consisting of a purge gas, a barrier gas, a carrier gas, an inert gas, Nitrogen and Argon.

The gas supply system of embodiments disclosed herein allows for introducing into the pumping system optimized amounts of a gas, for instance a purge gas, a barrier gas and/or a carrier gas. For the sake of simplicity, in the following, a gas supplied by the gas supply system is also referred to as a purge gas. The purge gas may e.g. have a molecular weight larger than the molecular weight of one component of the process gas to be pumped by the pumping system. A typical purge gas for pumping a process gas including a flammable or explosive gas, e.g. Hydrogen, is an inert gas, such as Nitrogen. The purge gas may flush the pumping system for cleaning. The purge gas may also establish a barrier inside of the pumping system during pumping, for avoiding a backstreaming of the pumped process gas or of components thereof into the process chamber. Furthermore, since the purge gas is pumped together with the process gas, it may function as a carrier gas and may carry away the process gas or components thereof and thereby reduce backstreaming thereof. In particular, a process gas component or components having a smaller molecular weight that the purge gas may be carried away by the purge gas. Hence, the pumping efficiency of the pumping system is increased. This is especially useful for pumping a process gas containing large amounts of light gases, i.e. gases having a small molecular weight, such as Hydrogen, e.g., depending on the size of the pumping system, an amount of Hydrogen of more than 20 slm.

In some examples of embodiments disclosed herein, the gas outlet of the first gas conduit 24 including the flow controller 26 may be fluidly connectable or fluidly connected, respectively, to the pumping system 10 at an upstream position of the pumping system. For instance, the upstream position of the pumping system may be a position upstream of one of the plurality of pumping means of the pumping system. In some examples, the upstream position of the pumping system may be a position between the upstream end of the pumping system and one of the pumping means. In further examples, the upstream position may be located between two of the pumping means.

According to one example of embodiments disclosed herein, the upstream position may be a position at one of the pumping means of the pumping system, e.g. at one of the upstream pumping means, such as one of the booster pumps. For instance, as shown in Fig. 3, each gas conduit 24, 25 of the gas supply system 20 may be provided with one gradient adjustment means 23 and the pump 14 of the pumping system 10 may be connected to the gas outlet of gas conduit 25. This example allows flushing the pumping means with the purge gas. Furthermore, a barrier and/or carrier effect of the purge gas introduced at the pumping means may also be provided.

In other examples of embodiments, the upstream position of the pumping system may be a position adjacent to the upstream end of the pumping system. Such an example is illustrated in e.g. Fig. 2b, wherein the first gas conduit 25 including the gas flow controller 26 is provided between the backing pump 14 and the process gas inlet 18. In such an arrangement, the purge gas introduced into the pumping system upstream of the backing pump 14 flushes the whole pumping system.

When pumping a process chamber, small amounts of the pumped gas, e.g. the process gas and/or even the purge gas used in a pumping arrangement, may stream back into the process chamber and may affect the process, e.g. a coating process, performed therein. This is avoided or prevented by embodiments described herein, which allow for providing at least one gradient of the purge gas amount supplied into the pumping system. For instance, using the gradient adjustments means, e.g. one or more gas flow controllers, of the gas supply system of embodiments, a gradient of the purge gas amount may be set, such that an amount of the gas supplied at an upstream position of the pumping system is less than an amount of the gas supplied at a downstream position of the pumping system. For example, the amounts of purge gas introduced at all or at some positions of the pumping system, e.g. at upstream positions, may be gradually reduced towards the process gas inlet. Alternatively, or in addition, in some embodiments, the gas outlet of each gas conduit may be connected to the pumping system downstream of one of the pumping means, e.g. downstream of the first backing pump which is located adjacent to the process gas inlet of the pumping system. In this case, no gas outlet of the gas supply system may be connected to the pumping system adjacent to the process gas inlet. This pumping arrangement also allows for avoiding the backstreaming of the purge gas.

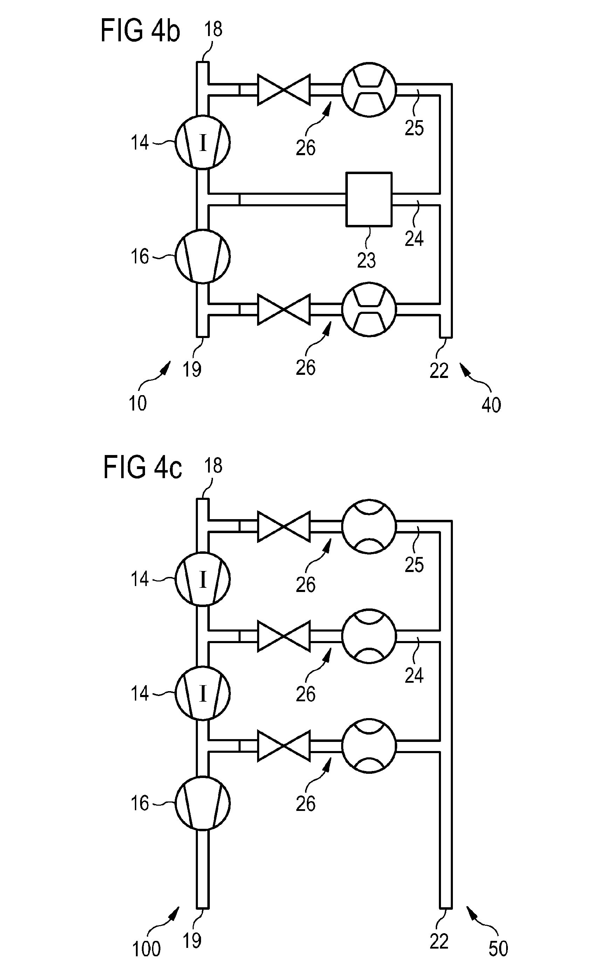

In other examples of a gas supply system according to embodiments disclosed herein, the gas outlet of a second gas conduit of the plurality of gas conduits is fluidly connectable to the pumping system at a position downstream of the connection to the first gas conduit, wherein the gradient adjustment means of the second gas conduit may include a gas flow controller. Moreover, in a pumping system according to embodiments, the gas outlet of the second gas conduit may be fluidly connected to the pumping system at a position downstream of the first pumping means, the second gas conduit being provided with a gradient adjustment means, e.g. a gas flow controller. Such examples of embodiments are e.g. shown in Figs. 4a to 4c. The pumping system 10 of Fig. 4a differs from the pumping system shown in Fig. 2b in that the second gas conduit 24 of a gas supply system 30 has gradient adjustment means being a gas flow controller 26. Fig. 4b illustrates the pumping system 10 being connected to a gas supply system 40 having three gas conduits, two of the gas conduits being provided with a gas flow controller 26, one of the gas conduits having a gradient adjustment means 23 being e.g. a throttle. In the example of embodiments according to Fig. 4c a pumping system 100 connected to a gas supply system 50 is shown, the pumping system 100 including a backing pump 16 and two booster pumps 14, the gas supply system 50 having three gas conduits each provided with a gradient adjustment means 23 being a gas flow controller 26. Hence, in each of the examples shown in Figs. 4a to 4c, when supplying a purge gas by the gas supply system of the present examples, at least two gas flow controllers may be used, in order to provide one or more optimized gradients of amounts of the purge gas introduced into the pumping system.

The one or more gradient adjustment means, e.g. gas flow controllers, of embodiments disclosed herein may each include at least one element selected from the group consisting of a flow sensor, a mass flow sensor, a throttle valve, a proportional control valve, a temperature sensor, a gas temperature sensor, a cooling means and a heating means. For instance, one or more of the gas flow controllers of embodiments disclosed herein may each be a mass flow controller (MFC). Furthermore, according to examples of embodiments, the pumping system, the gas supply system and/or at least the first gas conduit of the gas supply system may be provided with at least one element selected from the group consisting of a throttle valve, a proportional control valve, a pressure sensor, a temperature sensor, a gas temperature sensor, a cooling means and a heating means. As a result, not only the mass flow of the purge gas may be regulated, but also the pressure and the gas temperature inside of the gas supply and/or pumping system may be determined and adjusted using the gas supply system of embodiments described herein.

Hence, using embodiments disclosed herein, cooled or heated purge gas may be introduced into the pumping system. Thereby, an undesired increase of the temperature of the pumped process gas may be avoided by reducing the temperature of the mixture of process gas and purge gas. Moreover, an increase or a perpetuation of the gas temperature may be suitable for avoiding condensation of gases and deposits of contaminations or condensed gases inside of the pumping system. When measuring the gas temperature or another temperature in the pumping system, e.g. a pump temperature, the gas supply system and/or the pumping system of embodiments disclosed herein may be used to provide an optimized temperature gradient inside of the pumping system or an optimized temperature gradient of components of the pumping system.

According to further examples of embodiments, the gas supply system of embodiments disclosed herein may include a control system connected to and adapted to control at least one of the gradient adjustment means, e.g. at least one of the gas flow controllers, of the gas supply system. Hence, one or more optimized gradients of amounts of a purge gas introduced into the pumping system may be provided by centrally controlling one or more of the gradient adjustment means of the gas supply system. Moreover, the one or more gradients of amounts of a purge gas may be controlled depending on the process performed in the process chamber.

Moreover, the control system may be connected to and adapted to control at least one of the gradient adjustment means, at least one of the gas flow controllers, at least one of the flow sensors, at least one of the mass flow sensors, at least one of the throttle valves, at least one of the proportional control valves, at least one of the pressure sensors, at least one of the temperature sensors, at least one of the cooling means and/or at least one of the heating means of examples of embodiments. Hence, according to some examples of embodiments disclosed herein, not only the gas flow, but also the gas temperature of the purge gas supplied into the pumping system may be centrally monitored and/or controlled. Moreover, in a pumping system of embodiments disclosed herein, the control system of the gas supply system may be further connected to at least one of the pumping means and may be adapted to control at least one element selected from the group consisting of pumping speed and pump temperature. In addition, the control system may be connected to pressure gauges provided upstream and/or downstream of one or more throttle valves of the pumping system and to the corresponding throttle valves, in order to monitor and control the pressures inside of the pumping system in front of or behind the throttle valves. Hence, the control system may be provided with a plurality of information, such as pumping speeds, pump temperatures, gas temperatures, pressures in different regions of the pumping system and other process information. In one embodiment, the control system of the gas supply system and/or of the pumping system, respectively, may be part of the control system of the process chamber.

In some embodiments disclosed herein, the pumping system includes at least two gas supply systems which are in parallel connected to the pumping system. For instance, a first gas supply system as described above and a second gas supply system as described above may be connected to the pumping system in parallel to each other. In one example of embodiments, adjacent to and upstream of the connection of at least one gas outlet of the first gas supply system to the pumping system, a gas outlet of the second gas supply system is fluidly connected to the pumping system.

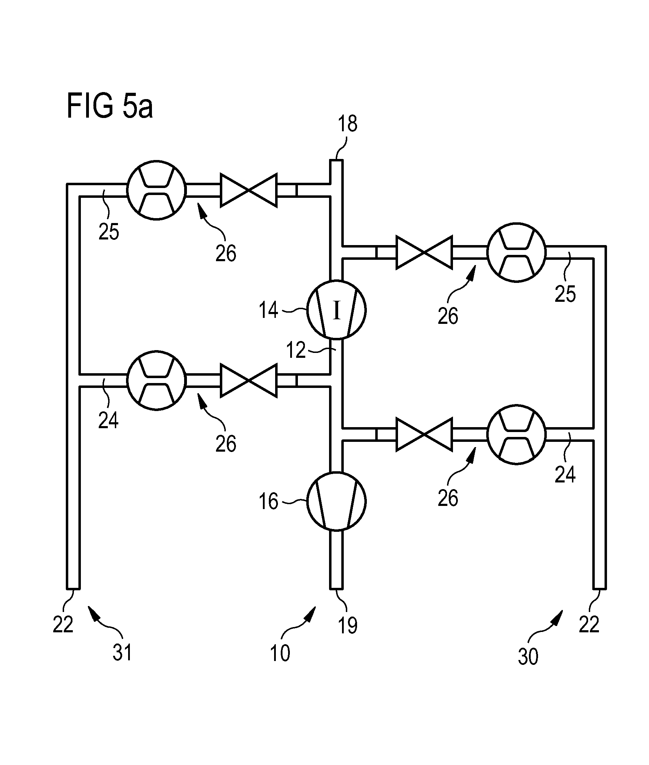

Fig. 5a illustrates an example of the pumping system 10 including two gas supply systems 30, 31, according to embodiments disclosed herein. As mentioned above referring to Fig. 1a and 1b, the pumping system 10 has the backing pump 16 and the booster pump 14 mounted in the pumping conduit 12. Each gas supply system 30, 31 includes two gas conduits 24, 25 each having a gradient adjustment means, which is in the present example a gas flow controller 26. As illustrated in Fig. 5a, the gas supply systems 30, 31 are each connected to the pumping system 10. Gas supply system 30 is shown in Fig. 5a to the right of the pumping system 10, whereas gas supply system 31 is shown in Fig. 5a to the left of the pumping system 10. Upstream of each gas conduit 24, 25 of the gas supply system 30, a gas conduit 24, 25 of the other gas supply system 31 is provided. As a result, upstream of the gas amounts supplied by the gas supply system 30, additional gas amounts may be introduced into the pumping system 10 by the gas supply system 31.

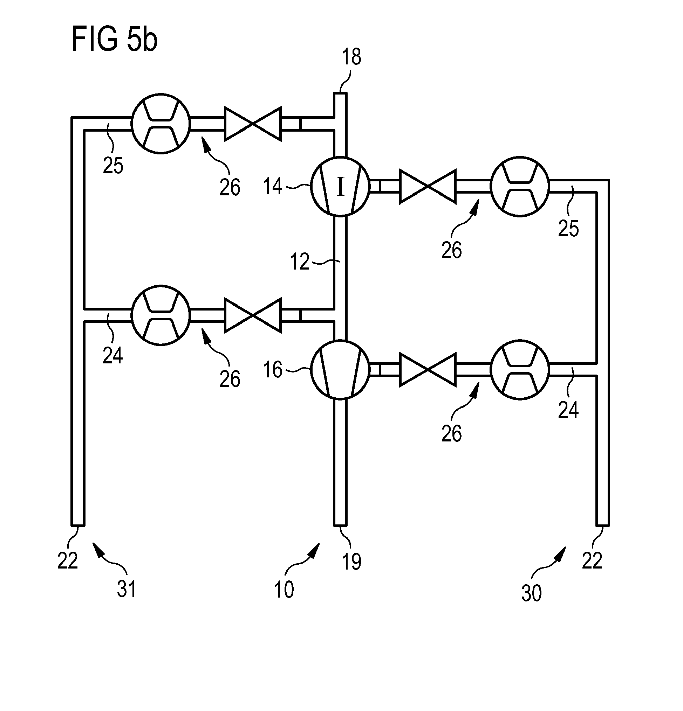

Moreover, in a variation of the example shown in Fig. 5a and as shown in Fig. 5b, each gas conduit 24, 25 of the gas supply system 30 may be provided with one gradient adjustment means 26, e.g. a gas flow controller, and the pumps 14 and 16 of the pumping system 10 may be each connected to one of the gas outlets of the gas conduits 24, 25 of the gas supply system 30. This example allows flushing the pumping means with the purge gas. Furthermore, a barrier and/or carrier effect of the purge gas introduced at the pumping means may also be provided.

When using the examples of embodiments including a first and a second gas supply system, the gas introduced into the pumping system by the first gas supply system may be the same as or may be different from the gas introduced by the second gas supply system. Introducing different gases may e.g. be suitable alternatively or in addition to the procedure of providing at least one gradient of supplied gas amounts, in order to minimize adverse effects, e.g. a backstreaming, of a first purge gas supplied by gas supply system 30. For instance, when supplying different purge gases by two gas supply systems, e.g. the gas supply systems 30 and 31 as shown in Fig. 5a or 5b, a second purge gas, e.g. Argon, may be supplied upstream of a first purge gas, e.g. Nitrogen. The second purge gas may be supplied by gas supply system 31 as a carrier gas or barrier gas for avoiding backstreaming of the first purge gas or other gases in the pumping system. In addition, the supplied amounts of the second purge gas may provide a diffusion barrier upstream of the introduced amounts of the first purge gas. Further, not only one or more gradients of the gas amounts of the first purge gas, but also one or more gradients of the gas amounts of the second purge gas may be provided. Moreover, the amounts of supplied first and second purge gases may be controlled such that one or more gradients of the introduced amounts of the mixture of both purge gases may be established. In some examples, the gas supplied by one or both gas supply systems may be a gas mixture, e.g. a mixture of Argon and Nitrogen. Depending on the actual condition of the process performed in the process chamber, in some embodiments, it may not be necessary to supply the second purge gas during all process steps. Rather, the second purge gas may be supplied to the pumping system only during process steps which are not or to a minor degree affected by the second purge gas.

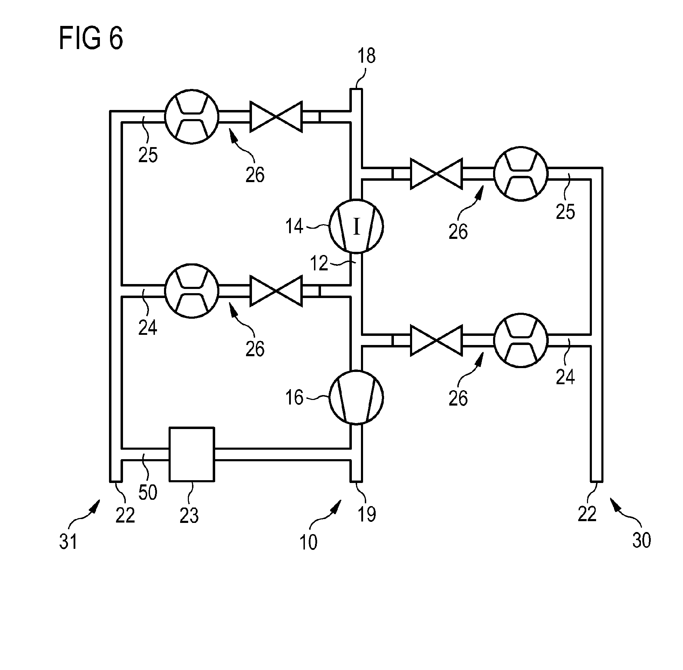

Fig. 6 shows a variation of the pumping system 10 shown in Fig. 5a. In this example of embodiments, the gas supply system 31 includes a further gas conduit 50 including a gradient adjustment means 23, e.g. a throttle providing a fixed gas flow. The gas conduit 50 is fluidly connected to the pumping conduit 12 downstream of the backing pump 16. Thereby, a further gradient of the gas amount flowing into the pumping system 10 may be established, the further gradient spanning backing pump 16. Moreover, the pumping efficiency of the backing pump 16 may be improved because of an additional barrier effect and/or carrier effect of the purge gas introduced downstream of the backing pump 16. This example may correspondingly be applied to any embodiment disclosed herein of a gas supply system, as well as of a pumping system or method utilizing only one gas supply system.

In embodiments described herein, the gas supply system may include a flow sensor, such as a gas flow sensor or a mass flow sensor, downstream of the gas inlet and upstream of the plurality of gas conduits.

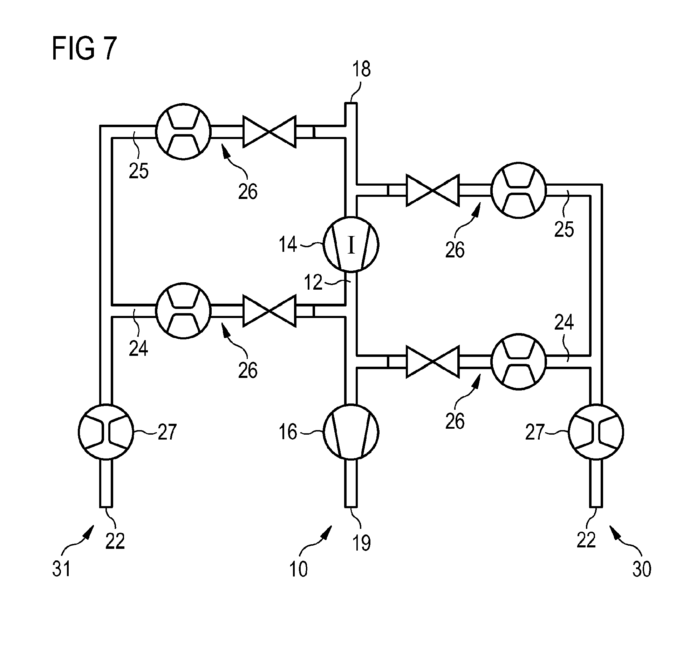

As an example, Fig. 7 shows a further variation of the pumping system 10 shown in Fig. 5a. According to this example of embodiments, downstream of each gas inlet 22 of gas supply systems 30 and 31, a gas flow sensor 27 is installed. This allows determination of the initially supplied gas amount in each gas supply system. Further, the total sum of the gas amounts supplied through all gas conduits of each gas supply system may be determined using the gas flow controllers 26. By comparing the initially supplied gas amount and the sum of the gas amounts supplied through the gas conduits of one of the gas supply system, a leak or other malfunction of the respective gas supply system may be recognized. This example may correspondingly be applied to any embodiment disclosed herein of a gas supply system, as well as of a pumping system or method utilizing only one gas supply system.

According to embodiments disclosed herein, gradient adjustment means, e.g. one or more gas flow controllers, may be included in the pumping system of a process chamber. Depending on the process performed in the process chamber, the gradient adjustment means, e.g. gas flow controllers, may be used, in order to provide one or more optimized gradients of gas amounts supplied into the pumping system, e.g. gradients of amounts of one or more purge gases, one or more barrier gases and/or one or more carrier gases. Using embodiments disclosed herein, the supplied gas or gases may be distributed over the pumping system and may be introduced predominantly between or upstream of one or more pumping means of the pumping system. Since the gas flow gradation between the pumping stages of the pumping system is dependent on the pumping speed, the pressure, the temperature and the type of gas inside of the pumping stages, in embodiments described herein the amounts of supplied gas or gases may be continuously changed using the gradient adjustment means, e.g. one or more gas flow controllers. For each process condition and/or for each pumping condition a gradient of the supplied amounts of gas may be determined and provided, which is optimized with respect to process technology, economics and safety engineering. This gradient may be appropriately adapted using embodiments described herein.

With embodiments disclosed herein, for each working point of a multi stage pumping installation, an optimum amount of purge gas and/or barrier gas and/or carrier gas may be continuously determined and adjusted. Simultaneously, the sums of the amounts of purge gas and/or barrier gas and/or carrier gas may be monitored, each amount being monitored independently. Hence, the gradient of the supplied purge gas amounts and/or barrier gas amounts and/or carrier gas amounts may be changed while maintaining the total sum thereof. The safety of operating the process chamber and/or the pumping installation is increased, since for each process step performed in the process chamber, safety-related appropriate purge, barrier and/or carrier gas amounts may be utilized and monitored, in some embodiments even multiply supplied and monitored. The performance of existent and future pumping installations may be improved, in particular pumping installations for pumping large flows, e.g. flows of more than several 100 slm, of gases having a small molecular weight.

Hence, embodiments described herein allow for increasing the performance of multi stage pumping installations of process chambers, e.g. the exhaustion rate. Purge gas, barrier gas and/or carrier gas may be utilized more selectively and more efficiently according to the process requirements. The costs of operating pumping installations of a variety of process chambers may be reduced, in particular by reducing the required amounts of purge, barrier and/or carrier gas. Furthermore, the safety of operating a multi stage pumping installation may be improved by a permanent correctly performed monitoring or even double or multiple monitoring of the purge, barrier and/or carrier gas supply.

Embodiments disclosed herein allow for an improvement of the efficiency of pumping gases, e.g. gases having a small molecular weight. By introducing optimized amounts of one or more purge, barrier and/or carrier gases into the pumping system, the consumption of purge, barrier and/or carrier gas during pumping of a process chamber may be reduced. Moreover, since in some embodiments the condensation and deposition of pumped gases, even of the purge, barrier and/or carrier gases, or of contaminations inside of the pumping system may be avoided, the reliability of the pumping operation is ensured and improved.

One embodiment provides a gas supply system for supplying a gas into a pumping system, the pumping system including a plurality of pumping means, the gas supply system including a gas inlet and plurality of gas conduits fluidly connected to the gas inlet and each having a gas outlet fluidly connectable to the pumping system, wherein the gas outlets of the plurality of gas conduits are in parallel fluidly connectable to the pumping system and each gas conduit is provided with a gradient adjustment means adapted to provide at least one gradient of gas amount supplied to the pumping system.

In one embodiment, which may be combined with any other embodiment disclosed herein, the gradient adjustment means includes at least one element selected from the group consisting of a gas flow restriction means and a gas flow adjustment means. The gas flow adjustment means may include a gas flow sensing means and a gas flow restriction means. For instance, the gradient adjustment means may include at least one element selected from the group consisting of an orifice, a nozzle, a valve, a throttle, a flow sensor, a control valve and a gas flow controller..

In one embodiment, which may be combined with any other embodiment disclosed herein, the gradient adjustment means of at least a first one of the gas conduits includes a gas flow controller.

In one embodiment, which may be combined with any other embodiment disclosed herein, the gas outlet of a second gas conduit of the plurality of gas conduits is fluidly connectable to the pumping system at a position downstream of the connection to the first gas conduit. Furthermore, the gradient adjustment means of the second gas conduit may include a gas flow controller.

In one embodiment, which may be combined with any other embodiment disclosed herein, the gas supply system may include a flow sensor, such as a gas flow sensor or a mass flow sensor, downstream of the gas inlet and upstream of the plurality of gas conduits

In one embodiment, which may be combined with any other embodiment disclosed herein, at least the first gas conduit is further provided with at least one element selected from the group consisting of a throttle valve, a proportional control valve, a pressure sensor, a temperature sensor, a gas temperature sensor, a cooling means and a heating means.

In one embodiment, which may be combined with any other embodiment disclosed herein, the gradient adjustment means includes at least one element selected from the group consisting of a flow sensor, a mass flow sensor, a throttle valve, a proportional control valve, a temperature sensor, a gas temperature sensor, a cooling means and a heating means.

One embodiment includes a control system connected to and adapted to control at least one element selected from the group consisting of at least one of the gradient adjustment means, the gas flow controller, the flow sensor, the mass flow sensor, the throttle valve, the proportional control valve, the temperature sensor, the cooling means and the heating means.

One embodiment provides a pumping system, including a pumping conduit; a plurality of pumping means; and a gas supply system including a gas inlet and including a plurality of gas conduits fluidly connected to the gas inlet and each having a gas outlet fluidly connectable to the pumping system, wherein each gas conduit is provided with a gradient adjustment means adapted to provide at least one gradient of gas amount supplied to the pumping system, and wherein the gas outlets of the plurality of gas conduits are in parallel fluidly connected to the pumping system. The plurality of pumping means may be consecutively provided in the pumping conduit.

In one embodiment, which may be combined with any other embodiment disclosed herein, a first one of the pumping means is located at an upstream position of the pumping system.

In one embodiment, which may be combined with any other embodiment disclosed herein, at least the first pumping means is selected from the group consisting of a pump for pumping light gases, a dry running pump, a forepump, a booster pump and a roots pump.

In one embodiment, which may be combined with any other embodiment disclosed herein, the gas outlet of the first gas conduit is fluidly connected to the pumping system at a position upstream of the first pumping means.

In one embodiment, which may be combined with any other embodiment disclosed herein, the gas outlet of a second one of the gas conduits is fluidly connected to the pumping system at a position downstream of the first pumping means.

In one embodiment, which may be combined with any other embodiment disclosed herein, the control system of the gas supply system is connected to at least one of the pumping means and is adapted to control at least one element selected from the group consisting of pumping speed and pump temperature.

In one embodiment of the pumping system, which may be combined with any other embodiment disclosed herein, the gas supply system is a first gas supply system and the pumping system further includes a second gas supply system, the second gas supply system including a gas inlet and including a plurality of gas conduits fluidly connected to the gas inlet and each having a gas outlet fluidly connectable to the pumping system, wherein each gas conduit of the second gas supply system is provided with a gradient adjustment means adapted to provide at least one gradient of gas amount supplied to the pumping system, wherein, adjacent to and upstream of the connection of at least one gas outlet of the first gas supply system to the pumping system, one gas outlet of the second gas supply system is fluidly connected to the pumping system.

In one embodiment, which may be combined with any other embodiment disclosed herein, adjacent to and upstream of the connection of the first gas outlet of the first gas supply system to the pumping system, the gas outlet of the first gas conduit of the second gas supply system is fluidly connected to the pumping system.

In one embodiment, which may be combined with any other embodiment disclosed herein, at least one of the pumping means is fluidly connected to one of the gas outlets.

In one embodiment, which may be combined with any other embodiment disclosed herein, the pumping system includes at least one valve, and at least one pressure sensor is provided in the pumping conduit adjacent to the at least one valve.

One embodiment provides a coating system, including a coating chamber and a gas supply system for supplying a gas into a pumping system of the coating chamber, the pumping system including a plurality of pumping means, the gas supply system including a gas inlet and plurality of gas conduits fluidly connected to the gas inlet and each having a gas outlet fluidly connectable to the pumping system, wherein the gas outlets of the plurality of gas conduits are in parallel fluidly connectable to the pumping system and each gas conduit is provided with a gradient adjustment means adapted to provide at least one gradient of gas amount supplied to the pumping system.

One embodiment provides a coating system, including a coating chamber and a pumping system including a pumping conduit, a plurality of pumping means, and a gas supply system including a gas inlet and including a plurality of gas conduits fluidly connected to the gas inlet and each having a gas outlet fluidly connectable to the pumping system, wherein each gas conduit is provided with a gradient adjustment means adapted to provide at least one gradient of gas amount supplied to the pumping system, and wherein the gas outlets of the plurality of gas conduits are in parallel fluidly connected to the pumping system. The plurality of pumping means may be consecutively provided in the pumping conduit.

In one embodiment, which may be combined with any other embodiment disclosed herein, the coating system includes at least one coating device selected from the group consisting of a sputtering device, a PVD device, a CVD device and a PECVD device.

According to a yet further embodiment, a gas supply method for supplying a gas into a pumping system is provided, the pumping system including a plurality of pumping means, the method including: supplying a gas into the pumping system through a first gas conduit and at least another gas conduit, the first gas conduit and the at least another gas conduit being fluidly connected to the pumping system in parallel to each other; and adjusting at least the amount of gas supplied through the first gas conduit such that at least one gradient of the gas amount supplied into the pumping system is provided.

In another embodiment, a pumping method for pumping a process gas by a pumping system is provided, the pumping system including a process gas inlet and a plurality of pumping means, the method including: supplying a gas into the pumping system through a first gas conduit and at least another gas conduit, the first gas conduit and the at least another gas conduit being fluidly connected to the pumping system in parallel to each other, adjusting at least the amount of gas supplied through the first gas conduit such that at least one gradient of the gas amount supplied into the pumping system is provided, and pumping a process gas introduced through the process gas inlet. Two or more of the steps of supplying, adjusting and/or pumping may be performed simultaneously or in any appropriate sequence.

In one embodiment, which may be combined with any other embodiment disclosed herein, the adjusting is performed continuously.

In one embodiment, which may be combined with any other embodiment disclosed herein, the adjusting is performed such that an amount of the gas supplied at an upstream position of the pumping system is less than an amount of the gas supplied at a downstream position of the pumping system.

In one embodiment, which may be combined with any other embodiment disclosed herein, the gas is at least one element selected from the group consisting of a purge gas, a barrier gas, a carrier gas, an inert gas, Nitrogen and Argon.

In one embodiment, which may be combined with any other embodiment disclosed herein, the adjusting includes controlling at least one element selected from the group consisting of a gas temperature of the gas supplied through at least one of the gas outlets, a temperature of at least one of the pumping means, and a pumping speed of at least one of the pumping means.

In one embodiment, which may be combined with any other embodiment disclosed herein, the pumping system includes a first gas supply system and a second gas supply system, the first gas conduit being part of the first gas supply system and one of the another gas conduits being part of the second gas supply system, and wherein optionally a first gas is supplied through the first gas supply system and a second gas is supplied through the second gas supply system.

In one embodiment, which may be combined with any other embodiment disclosed herein, the adjusting includes controlling a pressure in a pumping conduit of the pumping system, the controlling being performed adjacent to a valve of the pumping system.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A gas supply system for supplying a gas into a pumping system, the pumping system (10; 100) including a plurality of pumping means (14, 16),
the gas supply system (20; 50) comprising
a gas inlet (22) and
plurality of gas conduits (24, 25) fluidly connected to the gas inlet (22) and each having a gas outlet fluidly connectable to the pumping system,
wherein
the gas outlets (27, 28) of the plurality of gas conduits are in parallel fluidly connectable to the pumping system (10; 100), and
each gas conduit (24, 25) is provided with a gradient adjustment means (23) adapted to provide at least one gradient of gas amount supplied to the pumping system (10; 100).

2. The gas supply system of claim 1, wherein the gradient adjustment means (23) comprises at least one element selected from the group consisting of a gas flow restriction means and a gas flow adjustment means.

3. The gas supply system of claim 1 or 2, wherein the gradient adjustment means (23) of at least a first one (25) of the gas conduits comprises a gas flow controller (26).

4. The gas supply system of claim 3, wherein the gas outlet of the first gas conduit (25) is fluidly connectable to the pumping system at an upstream position (15) of the pumping system, and/or
wherein the gas outlet of a second gas conduit (24) of the plurality of gas conduits is fluidly connectable to the pumping system at a position (17) downstream of the connection to the first gas conduit, wherein the gradient adjustment means of the second gas conduit comprises a gas flow controller (26).

5. The gas supply system of any of the preceding claims, wherein at least one of the gas conduits is further provided with at least one element selected from the group consisting of a throttle valve, a proportional control valve, a pressure sensor, a temperature sensor, a gas temperature sensor, a cooling means and a heating means,
and/or wherein the gradient adjustment means comprises at least one element selected from the group consisting of a flow sensor, a mass flow sensor, a throttle valve, a proportional control valve, a temperature sensor, a gas temperature sensor, a cooling means and a heating means.

6. The gas supply system of any of the preceding claims, comprising a control system connected to and adapted to control at least one element selected from the group consisting of at least one of the gradient adjustment means, the gas flow controller, the flow sensor, the mass flow sensor, the throttle valve, the proportional control valve, the temperature sensor, the cooling means and the heating means.

7. A pumping system, comprising
a pumping conduit (12),
a plurality of pumping means (14, 16), and
a gas supply system (20; 50) according to any of claims 1 to 6, wherein the gas outlets (27, 28) of the plurality of gas conduits (24, 25) are in parallel fluidly connected to the pumping system (10; 100).

8. The pumping system of claim 7, wherein a first one (14) of the pumping means is located at an upstream position of the pumping system (10; 100), and/or wherein at least the first pumping means (14) is selected from the group consisting of a pump for pumping light gases, a dry running pump, a forepump, a booster pump and a roots pump.

9. The pumping system of claim 7, wherein the gas outlet (27) of the first gas conduit (25) is fluidly connected to the pumping system (10; 100) at a position (15) upstream of the first pumping means (14), and/or wherein the gas outlet (28) of the second gas conduit (24) is fluidly connected to the pumping system (10; 100) at a position downstream of the first pumping means (14).

10. The pumping system of any of claims 7 to 9, wherein the control system of the gas supply system is connected to at least one of the pumping means and is adapted to control at least one element selected from the group consisting of pumping speed and pump temperature.

11. The pumping system of any of claims 7 to 10, wherein the gas supply system is a first gas supply system and the pumping system further comprises a second gas supply system according to any of claims 1 to 6, wherein, adjacent to and upstream of the connection of at least one gas outlet of the first gas supply system to the pumping system, one gas outlet of the second gas supply system is fluidly connected to the pumping system.

12. A coating system, comprising a coating chamber and a gas supply system according to any of claims 1 to 6 or a pumping system according to any of claims 7 to 11, the coating system optionally comprising at least one coating device selected from the group consisting of a sputtering device, a PVD device, a CVD device and a PECVD device.

13. A gas supply method for supplying a gas into a pumping system,
the pumping system including a plurality of pumping means,
the method comprising
supplying a gas into the pumping system through a first gas conduit and
at least another gas conduit, the first gas conduit and the at least another gas conduit being fluidly connected to the pumping system in parallel to each other, and
adjusting at least the amount of gas supplied through the first gas conduit such that at least one gradient of the gas amount supplied into the pumping system is provided.

14. A pumping method for pumping a process gas by a pumping system,
the pumping system including a process gas inlet and a plurality of pumping means,
the method comprising
supplying a gas into the pumping system through a first gas conduit and
at least another gas conduit, the first gas conduit and the at least another gas conduit being fluidly connected to the pumping system in parallel to each other,
adjusting at least the amount of gas supplied through the first gas conduit such that at least one gradient of the gas amount supplied into the pumping system is provided, and
pumping a process gas introduced through the process gas inlet.

15. The method of claim 13 or 14, wherein the adjusting is performed such that an amount of the gas supplied at an upstream position of the pumping system is less than an amount of the gas supplied at a downstream position of the pumping system,
and/or wherein the gas is at least one element selected from the group consisting of a purge gas, a barrier gas, a carrier gas, an inert gas,
Nitrogen and Argon.

16. The method of any of claims 13 to 15, wherein the adjusting comprises controlling at least one element selected from the group consisting of a gas temperature of the gas supplied through at least one of the gas outlets, a temperature of at least one of the pumping means, and a pumping speed of at least one of the pumping means.

17. The method of any of claims 13 to 16, wherein the pumping system comprises a first gas supply system and a second gas supply system, the first gas conduit being part of the first gas supply system and one of the another gas conduits being part of the second gas supply system,
and/or wherein a first gas is supplied through the first gas supply system and a second gas is supplied through the second gas supply system.

## Amended claims

### Amended claims in accordance with Rule 137(2) EPC.

**1.** A gas supply system for supplying a gas into a pumping system, the pumping system (10; 100) including a plurality of pumping means (14, 16),
the gas supply system (20; 50) comprising
a gas inlet (22) and
plurality of gas conduits (24, 25) fluidly connected to the gas inlet (22) and each having a gas outlet fluidly connectable to the pumping system,
wherein
the gas outlets (27, 28) of the plurality of gas conduits are in parallel fluidly connectable to the pumping system (10; 100), and
each gas conduit (24, 25) is provided with a gradient adjustment means (23) adapted to provide at least one gradient of gas amount supplied to the pumping system (10; 100).

**2.** The gas supply system of claim 1, wherein the gradient adjustment means (23) comprises at least one element selected from the group consisting of a gas flow restriction means and a gas flow adjustment means.

**3.** The gas supply system of claim 1 or 2, wherein the gradient adjustment means (23) of at least a first one (25) of the gas conduits comprises a gas flow controller (26).

**4.** The gas supply system of claim 3, wherein the gas outlet of the first gas conduit (25) is fluidly connectable to the pumping system at an upstream position (15) of the pumping system, and/or
wherein the gas outlet of a second gas conduit (24) of the plurality of gas conduits is fluidly connectable to the pumping system at a position (17) downstream of the connection to the first gas conduit, wherein the gradient adjustment means of the second gas conduit comprises a gas flow controller (26).

**5.** The gas supply system of any of the preceding claims, wherein at least one of the gas conduits is further provided with at least one element selected from the group consisting of a throttle valve, a proportional control valve, a pressure sensor, a temperature sensor, a gas temperature sensor, a cooling means and a heating means,
and/or wherein the gradient adjustment means comprises at least one element selected from the group consisting of a flow sensor, a mass flow sensor, a throttle valve, a proportional control valve, a temperature sensor, a gas temperature sensor, a cooling means and a heating means.

**6.** The gas supply system of any of the preceding claims, comprising a control system connected to and adapted to control at least one element selected from the group consisting of at least one of the gradient adjustment means, the gas flow controller, the flow sensor, the mass flow sensor, the throttle valve, the proportional control valve, the temperature sensor, the cooling means and the heating means.

**7.** A pumping system, comprising
a pumping conduit (12),
a plurality of pumping means (14, 16), and
a gas supply system (20; 50) according to any of claims 1 to 6, wherein the gas outlets (27, 28) of the plurality of gas conduits (24, 25) are in parallel fluidly connected to the pumping system (10; 100).

**8.** The pumping system of claim 7, wherein a first one (14) of the pumping means is located at an upstream position of the pumping system (10; 100), and/or wherein at least the first pumping means (14) is selected from the group consisting of a pump for pumping light gases, a dry running pump, a forepump, a booster pump and a roots pump.

**9.** The pumping system of claim 7, wherein the gas outlet (27) of the first gas conduit (25) is fluidly connected to the pumping system (10; 100) at a position (15) upstream of the first pumping means (14), and/or
wherein the gas outlet (28) of the second gas conduit (24) is fluidly connected to the pumping system (10; 100) at a position downstream of the first pumping means (14).

**10.** The pumping system of any of claims 7 to 9, wherein the control system of the gas supply system is connected to at least one of the pumping means and is adapted to control at least one element selected from the group consisting of pumping speed and pump temperature.

**11.** The pumping system of any of claims 7 to 10, wherein the gas supply system is a first gas supply system and the pumping system further comprises a second gas supply system according to any of claims 1 to 6,
wherein, adjacent to and upstream of the connection of at least one gas outlet of the first gas supply system to the pumping system, one gas outlet of the second gas supply system is fluidly connected to the pumping system.

**12.** A coating system, comprising a coating chamber and a gas supply system according to any of claims 1 to 6 or a pumping system according to any of claims 7 to 11, the coating system optionally comprising at least one coating device selected from the group consisting of a sputtering device, a PVD device, a CVD device and a PECVD device.

**13.** A gas supply method for supplying a gas into a pumping system,
the pumping system including a plurality of pumping means,
the method comprising
supplying a gas into the pumping system through a first gas conduit and at least another gas conduit, the first gas conduit and the at least another gas conduit being fluidly connected to the pumping system in parallel to each other, and
adjusting at least the amount of gas supplied through the first gas conduit such that at least one gradient of the gas amount supplied into the pumping system is provided.

**14.** The method according to claim 13, wherein the gas is supplied for pumping a process gas by the pumping system,
the pumping system including a process gas inlet,
the method comprising
pumping a process gas introduced through the process gas inlet.

**15.** The method of claim 13 or 14, wherein the adjusting is performed such that an amount of the gas supplied at an upstream position of the pumping system is less than an amount of the gas supplied at a downstream position of the pumping system,
and/or wherein the gas is at least one element selected from the group consisting of a purge gas, a barrier gas, a carrier gas, an inert gas, Nitrogen and Argon.

**16.** The method of any of claims 13 to 15, wherein the adjusting comprises controlling at least one element selected from the group consisting of a gas temperature of the gas supplied through at least one of the gas outlets, a temperature of at least one of the pumping means, and a pumping speed of at least one of the pumping means.

**17.** The method of any of claims 13 to 16, wherein
the pumping system comprises a first gas supply system and a second gas supply system, the first gas conduit being part of the first gas supply system and one of the another gas conduits being part of the second gas supply system,
and/or wherein a first gas is supplied through the first gas supply system and a second gas is supplied through the second gas supply system.
